# EUROPÄISCHE PATENTSCHRIFT

(11) **EP 0 417 556 B1**
(45) Veröffentlichungstag und Bekanntmachung des Hinweises auf die Patenterteilung: **11.12.1996**
(21) Anmeldenummer: 90116607.4
(22) Anmeldetag: 30.08.1990
(51) Int. Cl.: G03F 7/004

(54) **Positiv-arbeitendes strahlungsempfindliches Gemisch und daraus hergestelltes Aufzeichnungsmaterial**
Positive-working radiation-sensitive mixture and recording material prepared therefrom
Composition sensible aux rayonnements à effet positif et matériel d'enregistrement sensible aux rayonnements produit par cette composition

(30) Priorität: 09.09.1989 DE 3930087
(43) Veröffentlichungstag der Anmeldung: 20.03.1991
(73) Patentinhaber: HOECHST AKTIENGESELLSCHAFT, 65926 Frankfurt am Main (DE)
(72) Erfinder: Pawlowski, Georg, Dr. Dipl.-Chem., D-65817 Wiesbaden (DE); Merrem, Hans-Joachim, Dr. Dipl.-Chem., Basking Ridge NJ 07920 (US); Lingnau, Jürgen, Dr. Dipl.-Chem., D-55130 Mainz (DE); Dammel, Ralph, Dr. Dipl.-Chem., Coventry R. I. 02816 (US); Röschert, Horst, Dr. Dipl.-Chem., D-55432 Ober-Hilbersheim (DE)

(56) Entgegenhaltungen:
- EP-A- 0 315 748
- FR-A- 2 071 655
- GB-A- 1 231 789
- US-A- 4 101 323

## Beschreibung

Die Erfindung betrifft ein positiv arbeitendes, strahlungsempfindliches Gemisch, das als wesentliche Bestandteile
a) 0,5 bis 25 Gew.-% eine bei Bestrahlung eine starke Säure bildende Verbindung,
b) eine Verbindung mit mindestens einer durch Säure spaltbaren C-O-C- oder C-O-Si-Bindung und
c) ein in Wasser unlösliches, in wäßrig-alkalischen Lösungen lösliches oder zumindest quellbares Bindemittel
enthält.

Die Erfindung betrifft weiterhin ein daraus hergestelltes strahlungsempfindliches Aufzeichnungsmaterial, das zur Herstellung von Photoresists, elektronischen Bauteilen, Druckplatten oder zum Formteilätzen geeignet ist.

Bei der UV-Lithographie ist die Grenze der Auflösung durch die Wellenlänge der verwendeten Strahlung vorgegeben. Die stetige Verkleinerung der Strukturdimensionen, beispielsweise in der Chip-Herstellung, erfordert daher im Submikronbereich veränderte Lithographietechniken. Wegen ihrer kurzen Wellenlänge werden beispielsweise energiereiches UV-Licht oder Elektronen- und Röntgenstrahlen verwendet. Die Veränderung der Lithographietechniken äußert sich insbesondere aber in einer Veränderung der Ansprüche an das strahlungsempfindliche Gemisch. Eine Zusammenstellung dieser Ansprüche wird beispielsweise im Aufsatz von C.G. Willson "Organic Resist Materials-Theory and Chemistry" (Introduction to Microlithography, Theory, Materials, and Processing, Herausgeber L.F. Thompson, C.G. Willson, M.J. Bowden, ACS Symp. Ser., 219, 87 (1983), American Chemical Society, Washington) gegeben. Es besteht daher ein verstärkter Bedarf an strahlungsempfindlichen Gemischen, die vorzugsweise in einem weiten Spektralbereich empfindlich sind und dementsprechend in der konventionellen UV-Lithographie oder ohne Empfindlichkeitseinbußen in den fortgeschrittenen Technologien, wie z.B. der Mid- oder Deep-UV-, Elektronenoder Röntgenstrahllithographie, einsetzbar sind.

In GB-A 1 231 789 sind Aufzeichnungsmaterialien mit einer strahlungsempfindlichen Schicht beschrieben, die aus einem α-Carbonyl-α-sulfonyl-diazomethan sowie gegebenenfalls einem in wäßrig-alkalischer Lösung löslichen, polymeren Bindemittel besteht. Diese Schicht besteht entweder vollständig aus dem Diazomethan oder enthält zumindest einen sehr großen Anteil davon.

Gemische der oben genannten Zusammensetzung sind prinzipiell bekannt und beispielsweise in den DE-A 23 06 248 (= US-A 3,779,778), 26 842 (= US-A 4,101,323), 27 18 254 (= US-A 4,247,611), 27 18 259 (= US-A 4,189,323), 29 28 636 (= US-A 4,311,782), 31 51 078 (= US-A 4,506,006), 35 44 165 (= US-A 4,786,577), 36 01 264 (= US-A 4,840,867), 37 30 783, 37 30 785 und 37 30 787, den EP-A 0 006 626 (= US-A 4,250,247), 0 006 627 (US-A 4,248,957), 0 042 562 (= US-A 4,506,003), 0 202 196 und 0 302 359 sowie den US-A 4,491,628 und 4,603,101 beschrieben.

Bei der Belichtung der vorstehend beschriebenen Materialien wird durch die Photolyse der Verbindung (a) eine Säure gebildet, die eine Spaltung der C-O-C-oder C-O-Si-Bindung der Verbindung (b) in der Weise bewirkt, daß die belichteten Bereiche der lichtempfindlichen Schichten in einem wäßrig-alkalischen Entwickler löslich werden.

Als Verbindungen (a), die als photolytische Säurespender charakterisiert werden können, wurden bisher insbesondere Onium-Salze, wie Diazonium-, Phosphonium-, Sulfonium- und Jodonium-Salze von nicht nukleophilen Säuren, z.B. von HSbF₆, HAsF₆, oder HPF₆ (J.V. Crivello, Polym. Eng. Sci., 23, 953 (1983)), Halogenverbindungen (EP-A 0 232 972, DE-A 15 72 089 (= GB-A 1 163 324), DE-A 18 17 540 (= US-A 3,615,455), DE-A 19 49 010 (= US-A 3,686,084), DE-A 23 17 846 (= GB-A 1 381 471 und 1 381 472), US-A 3,912,606), insbesondere Trichlormethyltriazinderivate (DE-A 12 98 414 (= GB-A 1 234 648), 22 43 621 (= GB-A 1 388 492), 23 06 248, 27 18 259, 33 33 450 (= ZA 84/7165) und 33 37 024 (= US-A 4,619,998 und 4,696,888) sowie US-A 3,515,552, 3,536,489 und 3,615,630) oder Trichlormethyloxadiazolderivate (DE-A 28 51 472 (= US-A 4,212,970 und 4,232,106), 29 49 396 (= US-A 4,279,982), 30 21 590 (= US-A 4,371,607), 30 21 599 (= US-A 4,371,606) und DE-A 33 33 450), o-Chinondiazidsulfochloride oder Organometall-Organohalogen-Kombinationen empfohlen.

Die Verwendung derartiger photolytischer Säurespender bringt aber gewisse Nachteile mit sich, die ihre Einsatzmöglichkeiten in verschiedenen Anwendungsbereichen drastisch einschränken. So sind z.B. viele der Oniumsalze toxisch. Ihre Löslichkeit ist in vielen Lösungsmitteln unzureichend, was in einer Begrenzung der Auswahl der Belackungslösungsmittel resultiert. Darüber hinaus werden bei Verwendung der Oniumsalze z.T. unerwünschte Fremdatome eingeführt, die insbesondere in der Mikrolithographie zu Prozeßstörungen führen können. Ferner bilden sie bei der Photolyse sehr stark korrodierend wirkende Bronstedt-Säuren, die den Einsatz von diese enthaltenden strahlungsempfindlichen Gemischen auf empfindlichen Substraten unbefriedigend machen. Auch die Halogenverbindungen sowie die Chinondiazidsulfonsäurechloride bilden stark korrosiv wirkende Halogenwasserstoffsäuren. Ferner besitzen derartige Verbindungen auf gewissen Substraten nur eine begrenzte Haltbarkeit, die entsprechend den Lehren der DE-A 36 21 376 (= US-A 4,840,867) in der Vergangenheit dadurch verbessert wurde, daß zwischen Substrat und strahlungsempfindlicher, Verbindungen des Typs (a) enthaltender Schicht eine Zwischenschicht eingezogen wurde, was allerdings zu einer unerwünschten Zunahme von Defekten und einer Verminderung der Prozeßreproduzierbarkeit führt. Es bestand darüber hinaus bisher die Auffassung, daß Verbindungen des Typs (b) nur durch die oben beschriebenen, in der lichtempfindlichen Schicht gut beweglichen Säuretypen spaltbar seien.

Neuere Arbeiten von F.M. Houlihan et al., SPIE 920, 67 (1988) haben jedoch gezeigt daß neben den oben genannten Säurespendern auch Nitrobenzyltosylate, die bei Belichtung wenig bewegliche Sulfonsäuren bilden, in gewissen säurelabilen Resistformulierungen verwendbar sind. Die dabei erzielten Empfindlichkeiten und die thermische Stabilität der Photoresiste erwiesen sich jedoch als unzureichend.

Wegen der aufgeführten Nachteile besteht daher ein Bedarf an weiteren photolytisch wirkenden Säurespendern, die als Bestandteile von strahlungsempfindlichen Gemischen die oben beschriebenen Nachteile nicht aufweisen und die somit eine ausreichende Reaktivität und Säurestarke besitzen, um Verbindungen des Typs (b) auch bei kurzen Belichtungszeiten in ihre Spaltprodukte zu überführen.

Aufgabe der Erfindung war es daher, ein strahlungsempfindliches Gemisch auf Basis von säurebildenden in Kombination mit Säurespaltbaren Verbindungen vorzuschlagen, wobei die photolytisch eine säure bildende Verbindung (a) möglichst stabil auf allen bekannten Substraten sein sollte und als Photoprodukt eine nicht korrosiv wirkende Säure generiert.

Erfindungsgemäß wird ein strahlungsempfindliches Gemisch vorgeschlagen, das als wesentliche Bestandteile
a) 0,5 bis 25 Gew.-% eine unter Einwirkung aktinischer Strahlung eine starke Säure bildende Verbindung,
b) eine Verbindung mit mindestens einer durch Säure spaltbaren C-O-C- oder C-O-Si-Bindung und
c) ein in Wasser unlösliches, in wäßrig-alkalischen Lösungen lösliches oder zumindest quellbares Bindemittel
enthält.

Das erfindungsgemäße Gemisch ist dadurch gekennzeichnet, daß die bei Bestrahlung eine starke Säure bildende Verbindung (a) ein α-Carbonyl-α-sulfonyl-diazomethan der allgemeinen Formel I 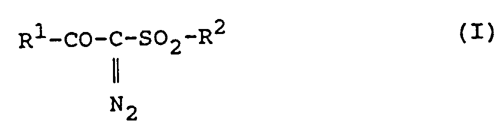 ist, worin
R¹ und R² voneinander unabhängig einen ggf. substituierten Alkyl-, Cycloalkyl-, Aryl- oder Heteroarylrest bedeuten.

Erfindungsgemäß wird darüber hinaus ein strahlungsempfindliches Aufzeichnungsmaterial vorgeschlagen, das auf einem Träger als strahlungsempfindliche Schicht das oben beschriebene Gemisch enthält.

Das erfindungsgemäße strahlungsempfindliche Gemisch zeichnet sich durch eine hohe Empfindlichkeit über einen weiten Spektralbereich aus. Es zeigt eine hohe thermische Stabilität und schafft die Möglichkeit, auch feinste Strukturen einer Vorlage strukturgenau wiederzugeben. Durch die Belichtung werden keine korrodierenden Photolyseprodukte gebildet, so daß das Gemisch auch auf empfindlichen Substratmaterialien Verwendung finden kann.

Für die Herstellung des strahlungsempfindlichen Gemischs können Verbindungen der allgemeinen Formel I verwendet werden, in denen R¹ und R² je einen voneinander unabhängigen, ggf. substituierten Alkyl-, Cycloalkyl-, einen ggf. substituierten Arylrest oder einen ggf. substituierten Heteroarylrest darstellen.

Beispiele geeigneter Substituenten R¹ und R² in α-Carbonyl-α-sulfonyl-diazomethanen der allgemeinen Formel I sind:

Methyl-, Ethyl-, Propyl-, Butyl-, Pentyl-, Hexyl-, Cyclohexyl-, Nonyl-, Decyl- oder Undecylgruppen, sowie deren Stellungsisomere, Benzol und Naphthalin sowie deren Derivate, in denen ein oder mehrere Wasserstoffatome beispielsweise durch Alkyl-, Alkoxy-, Alkoxyalkyl-, Aryl-, Aryloxy-, Arylalkoxy-, Halogen-, Cyano-, Nitro-, Carbonyl-, Carboxyl- oder ähnliche Reste substituiert sind. Besonders bevorzugte Substituenten sind Alkyl, Alkoxy, Alkoxyalkyl, Halogene, insbesondere Chlor oder Brom, sowie Cyano, wobei Alkyl- bzw. Alkoxyalkylreste insbesondere 1 bis 3-Atome enthalten.

Unter den Verbindungen der allgemeinen Formel I sind solche bevorzugt, in denen R¹ oder R² voneinander unabhängig einen Alkylrest mit 1 bis 6 Kohlenstoffatomen oder einen ggf. substituierten Arylrest aufweisen, und mindestens einer der Reste R¹ oder R² einen ggf. substituierten Arylrest darstellt, wobei ein- oder zweikernige Arylreste besonders bevorzugt sind.

Besonders bevorzugt sind Verbindungen der allgemeinen Formel I, in denen R¹ und R² mindestens einen voneinander unabhängigen ggfs. substituierten Arylrestrest darstellen, insbesondere
Methylsulfonyl-benzoyl-diazomethan
Ethylsulfonyl-benzoyl-diazomethan
Methylsulfonyl-4-brom-benzoyl-diazomethan
Ethylsulfonyl-4-brom-benzoyl-diazomethan
Phenylsulfonyl-benzoyl-diazomethan
Phenylsulfonyl-m-toluoyl-diazomethan
Phenylsulfonyl-p-toluoyl-diazomethan
Phenylsulfonyl-3-methoxy-benzoyl-diazomethan
Phenylsulfonyl-4-methoxy-benzoyl-diazomethan
Phenylsulfonyl-3-chlor-benzoyl-diazomethan
Phenylsulfonyl-4-chlor-benzoyl-diazomethan
Phenylsulfonyl-2-brom-benzoyl-diazomethan
Phenylsulfonyl-3-brom-benzoyl-diazomethan
Phenylsulfonyl-4-brom-benzoyl-diazomethan
Phenylsulfonyl-4-cyano-benzoyl-diazomethan
Phenylsulfonyl-1-naphthoyl-diazomethan
Phenylsulfonyl-2-naphthoyl-diazomethan
P-Tolylsulfonyl-benzoyl-diazomethan
P-Tolylsulfonyl-m-toluoyl-diazomethan
P-Tolylsulfonyl-p-toluoyl-diazomethan
P-Tolylsulfonyl-3-methoxy-benzoyl-diazomethan
P-Tolylsulfonyl-4-methoxy-benzoyl-diazomethan
P-Tolylsulfonyl-3-chlor-benzoyl-diazomethan
P-Tolylsulfonyl-4-chlor-benzoyl-diazomethan
P-Tolylsulfonyl-2-brom-benzoyl-diazomethan
P-Tolylsulfonyl-3-brom-benzoyl-diazomethan
P-Tolylsulfonyl-4-brom-benzoyl-diazomethan
P-Tolylsulfonyl-4-cyano-benzoyl-diazomethan
P-Tolylsulfonyl-1-naphthoyl-diazomethan
P-Tolylsulfonyl-2-naphthoyl-diazomethan

Diese Verbindungen sind deshalb besonders geeignet, weil sie einerseits eine hohe Photolysereaktivität aufweisen, andererseits aber eine ausreichende thermische Stabilität besitzen.

Die Herstellung der erfindungsgemäß eingesetzten α-Carbonyl-α-sulfonyl-diazomethanderivate ist an sich bekannt. Ihre Herstellung wurde beispielsweise von W. Illger, A. Liedgehegener und M. Regitz, Ann., 760, 1 (1972) beschrieben. Eine Zusammenfassung ihrer Herstellung und Eigenschaften wurde von M. Regitz und G. Maas in dem Buch "Diazo Compounds, Properties and Synthesis", Academic Press, Orlando, 1986 gegeben.

Darüber hinaus wurde ihre Verwendung als Lösungsinhibitoren für positiv arbeitende Materialien, insbesondere für Druckplatten, in der Vergangenheit von A. Poot et al., J. Photogr. Sci., 19, 88 (1971), untersucht; ihre praktische Eignung in Photoresistformulierungen wurde aber wegen unzureichender Lichtempfindlichkeit ausgeschlossen.

Es war daher besonders überraschend, daß die erfindungsgemäß eingesetzten Verbindungen der allgemeinen Formel I bei ihrer Photolyse ausreichende Mengen von ausreichend starken Säuren bilden, die die Herstellung des erfindungsgemäßen, hochempfindlichen positiv arbeitenden strahlungsempfindlichen Gemischs erlauben. Wenngleich keine genauen Vorstellungen über das Ausmaß und die Art der gebildeten Säuren bestehen, so ist doch davon auszugehen, daß sich insbesondere Sulfon- oder Sulfinsäuren durch die Photolyse bilden.

Gegenüber den bisher verwendeten photolytisch erzeugten Säuren, wie beispielsweise Chlorwasserstoffsäure, zeigen diese Säuren infolge ihres hohen Molekukargewichts eine viel geringere Diffusionsneigung bzw. Beweglichkeit im erfindungsgemäßen strahlungsempfindlichen Gemisch, so daß es einerseits überraschend war, daß eine höchsten Ansprüchen genügende Bilddifferenzierung erreicht werden konnte, und andererseits aber umso überraschender, daß der Kontrast und damit das Auflösungsvermögen des strahlungsempfindlichen Gemischs bei vergleichbarer Empfindlichkeit noch gesteigert wurde. Weiterhin war es überraschend, daß die α-Carbonyl-α-sulfonyl-diazomethane der allgemeinen Formel I auch durch energiereiche, kurzwellige Strahlung aktivierbar sind, und damit beispielsweise die Herstellung eines hochempfindlichen Photoresists für energiereiche UV2-Strahlung (248 nm) möglich ist. Insbesondere war es aber unerwartet, daß sogar noch im Bereich der klassischen optischen Lithographie (436 nm) eine ausreichende spektrale Ansprechbarkeit vorhanden ist.

Als aktinische Strahlung soll in diesem Zusammenhang jede Strahlung verstanden werden, deren Energie mindestens der des kurzwelligen sichtbaren Lichts entspricht. Geeignet ist dabei insbesondere UV-Strahlung im Bereich von 190 bis 450 nm, bevorzugt von 200 bis 400 nm, besonders bevorzugt von 200 bis 300 nm, aber auch Elektronen- oder Röntgenstrahlung.

Die Herstellung der erfindungsgemäß eingesetzten, z.T. neuen α-Carbonyl-α-sulfonyl-diazomethane wird anhand des bevorzugten p-Phenylsulfonyl-4-brom-benzoyl-diazomethans verdeutlicht (GT = Gewichtsteile):

27,8 GT 4-Bromphenacylbromid und 16.4 GT Natriumbenzolsulfinat werden in 250 GT Ethanol suspendiert und 5 Stunden zum Rückfluß erhitzt. Die noch warme Lösung wird filtriert. Nach der Abkühlung wird der gebildete Niederschlag abgesaugt und aus Ethanol umkristallisiert. Man erhält 25,5 GT fast farbloser Kristalle, die sich als analysenreines Phenylsulfonyl-(4-brom-benzoyl)-methan erweisen.

10 GT des vorstehend erhaltenen Produkts werden zusammen mit 4,8 GT Tosylazid in 90 GT Acetonitril gelöst und auf 0°C gekühlt. Zu dieser Mischung werden 2,5 GT Triethylamin derart zugetropft, daß die Temperatur unterhalb von 10°C bleibt. Die Mischung wird 8 Stunden bei Raumtemperatur nachgerührt und anschließend vom Lösungsmittel befreit. Der Rückstand wird in Methylenchlorid aufgenommen und zweimal mit 100 GT 5% wässriger Natriumhydroxyd-Lösung extrahiert, neutral gewaschen und getrocknet. Nach Abdampfen des Lösungsmittels verbleibt ein Feststoff, der aus Essigester umkristallisiert wird. Man erhält 7.5 GT blaßgelber Kristalle mit einem Zersetzungspunkt von 122 °C, die sich als analysenreines Phenylsulfonyl-(4-brombenzoyl)-diazomethan erweisen.

Die Analyse dieser Verbindung ergab folgende Werte:

| | | | | | |
|---|---|---|---|---|---|
| ber.: | C 46,02%, | H 2,47%, | N 7,67%, | S 8,76%, | Br 21,91% |
| gef.: | C 47,1 %, | H 2,3 %, | N 7,5 %, | S 8,4 %, | Br 22,7 % |

¹H-NMR (CDCl₃): 7.4 - 8.2 ppm (m, 9 H).
λₘₐₓ(CHCl₃)= 242 nm.

Auf analoge Weise lassen sich die anderen, oben genannten Verbindungen der allgemeinen Formel I herstellen.

Die im erfindungsgemäßen strahlungsempfindlichen Gemisch enthaltenen photolytischen Säurespender können allein oder in Kombination mit anderen Säurespendern der genannten Klasse Verwendung finden. Es sind aber auch Kombinationen mit anderen photolytischen Säurespendern möglich, wozu sich insbesondere die in der gleichzeitig eingereichten deutschen Anmeldung P 39 30 086.2 (= EP-A-417 557) beschriebenen α,α-Bis-sulfonyl-diazomethane eignen.

Darüber hinaus lassen sich die erfindungsgemäßen Säurespender der allgemeinen Formel I auch mit Onium-Salzen, wie Diazonium-, Phosphonium-, Sulfonium- und Jodonium-Salzen von nicht nukleophilen Säuren, z.B. von HSbF₆, HAsF₆, oder HPF₆ (J.V. Crivello, Polym. Eng. Sci., 23, 953 (1983), Halogenverbindungen (EP-A 0 232 972, DE-A 15 72 089, DE-A 18 17 540, DE-A 19 49 010, US-A 3,912,606, DE-A 23 17 846), insbesondere Trichlormethyltriazinderivaten (US-A 3,515,552, 3,536,489, 3,615,630 und 3,779,778, DE-A 27 18 259, DE-A 33 37 024, DE-A 33 33 450, DE-A 23 06 248, DE-A 22 43 621, DE-A 12 98 414) oder Trichlormethyloxadiazolderivaten (DE-A 30 21 590, DE-A 30 21 599, DE-A 28 51 472, DE-A 29 49 396, DE-A 33 33 450, EP-A 135 348), o-Chinondiazidsulfochloriden oder Organometall-Organohalogen-Kombinationen kombinieren. Derartige Kombinationen sind aber insgesamt nicht bevorzugt, da in solchen strahlungsempfindlichen Gemischen die eingangs erwähnten Nachteile wieder auftreten.

Der Gehalt an Säurespendern der allgemeinen Formel I im erfindungsgemäßen Gemisch liegt bevorzugt bei 1 bis 10 Gew.-%, jeweils bezogen auf das Gesamtgewicht der Schicht.

Als säurespaltbares Material in dem erfindungsgemäßen strahlungsempfindlichen Gemisch haben sich vor allem folgende Verbindungsklassen bewährt:
a) solche mit mindestens einer Orthocarbonsäureester- und bzw. oder Carbonsäureamidacetalgruppierung, wobei die Verbindungen auch polymeren Charakter haben und die genannten Gruppierungen als verknüpfende Elemente in der Hauptkette oder als seitenständige Substituenten auftreten können,
b) Oligomer- oder Polymerverbindungen mit wiederkehrenden Acetal- und/oder Ketalgruppierungen in der Hauptkette,
c) Verbindungen mit mindestens einer Enoletheroder N-Acyliminocarbonatgruppierung,
d) cyclische Acetale oder Ketale von ß-Ketoestern oder -amiden,
e) Verbindungen mit Silylethergruppierungen,
f) Verbindungen mit Silyl-enolethergruppierungen,
g) Monoacetale bzw. Monoketale, deren Aldehyd- bzw. Ketonkomponente eine Löslichkeit im Entwickler zwischen 0,1 und 100 g/l aufweisen,
h) Ether auf der Basis tertiärer Alkohole und
i) Carbonsäureester und Carbonate tertiärer, allylischer oder benzylischer Alkohole.

Durch Säure spaltbare Verbindungen des Typs (a) als Komponenten strahlungsempfindlicher Gemische sind in den DE-A 26 10 842 und 29 28 636 ausführlich beschrieben. Gemische, die Verbindungen des Typs (b) enthalten, sind in den DE-C 23 06 248 und 27 18 254 dargestellt. Verbindungen des Typs (c) werden in den EP-A 0 006 626 und 0 006 627 beschrieben. Verbindungen des Typs (d) werden in der EP-A 0 202 196 und Verbindungen, die dem Typ (e) zuzurechnen sind, in den DE-A 35 44 165 und 36 01 264 vorgestellt. Verbindungen des Typs (f) findet man in den DE-A 37 30 785 und 37 30 783, während Verbindungen vom Typ (g) in der DE-A 37 30 787 behandelt werden. Verbindungen vom Typ (h) werden z. B. in der US-A 4,603,101 beschrieben und Verbindungen vom Typ (i) z. B. in der US-A 4,491,628 sowie von J. M. Frechet et al., J. Imaging Sci. 30, 59-64 (1986).

Es können auch Mischungen der genannten säurespaltbaren Materialien eingesetzt werden. Bevorzugt ist allerdings ein säurespaltbares Material, das einem der obengenannten Typen zuzuordnen ist, und darunter besonders diejenigen, die eine durch Säure spaltbare C-O-C-Bindung aufweisen. Besonders bevorzugt sind diejenigen Materialien, die den Typen (a), (b), (g) und (i) angehören. Unter Typ (b) sind besonders die polymeren Acetale hervorzuheben; von den säurespaltbaren Materialien des Typs (g) insbesondere diejenigen, deren Aldehyd- bzw. Ketonkomponente einen Siedepunkt von größer als 150 °C, vorzugsweise größer als 200 °C, aufweist.

Der Gehalt an säurespaltbarem Material in dem erfindungsgemäßen strahlungsempfindlichen Gemisch sollte bei 1 bis 50 Gew.-%, vorzugsweise bei 5 bis 25 Gew.-%, jeweils bezogen auf das Gesamtgewicht der Schicht, liegen.

Das erfindungsgemäße strahlungsempfindliche Gemisch enthält ferner mindestens ein polymeres, in Wasser unlösliches, in wäßrigen alkalischen Lösungen aber lösliches, zumindest aber quellbares Bindemittel. Das Bindemittel zeichnet sich im besonderen dadurch aus, daß es die Bestandteile des erfindungsgemäßen strahlungsempfindlichen Gemisches gut löst und insbesondere im Wellenlängenbereich von 190 bis 300 nm eine möglichst geringe Eigenabsorption, d.h. eine hohe Transparenz, aufweist. Hierunter fallen insbesondere nicht diejenigen Bindemittel auf der Basis von Novolak-Kondensationsharzen, die in der Regel in Kombination von Naphthochinondiaziden als photoaktive Komponenten eingesetzt worden sind. Zwar lassen Novolak-Kondensationsharze nach bildmäßiger Belichtung in den nicht belichteten Bereichen eine Erniedrigung der Löslichkeit gegenüber wäßrig-alkalischen Entwicklern erkennen, doch ist ihre Eigenabsorption in dem für die Belichtung gewünschten Wellenlängenbereich unerwünscht hoch.

Die genannten Novolak-Kondensationsharze können aber in Mischung mit anderen als Bindemittel geeigneten Harzen mit höherer Transparenz eingesetzt werden. Die Mischungsverhältnisse richten sich dabei vorwiegend nach der Art des mit dem Novolakharz zu mischenden Bindemittels. Insbesondere spielen dessen Grad an Eigenabsorption im genannten Wellenlängenbereich, aber auch die Mischbarkeit mit den anderen Bestandteilen des strahlungsempfindlichen Gemisches eine entscheidende Rolle. Im allgemeinen kann aber das Bindemittel des erfindungsgemäßen strahlungsempfindlichen Gemisches bis zu 30 Gew.-%, insbesondere bis zu 20 Gew.-%, eines Novolak-Kondensationsharzes enthalten.

Als Bindemittel geeignet sind Homo- oder Copolymere des p-Hydroxystyrols sowie seiner Alkylderivate, z.B. des 3-Methylhydroxystyrols, sowie Homo- oder Copolymere anderer Polyvinylphenole, z. B. des 3-Hydroxystyrols oder die Ester oder Amide von Acrylsäure mit phenolische Gruppen aufweisenden Aromaten. Als Comonomere im Copolymeren können polymerisierbare Verbindungen wie Styrol, Methacrylsäuremethacrylat, Acrylsäuremethacrylat oder ähnliche eingesetzt werden.

Gemische mit erhöhter Plasmabeständigkeit werden dann erhalten, wenn zur Herstellung von Copolymeren des obigen Typs Silizium enthaltende Vinylmonomere, z. B. Vinyltrimethylsilan, verwendet werden. Die Transparenz dieser Bindemittel ist im interessierenden Bereich im allgemeinen höher, so daß eine verbesserte Strukturierung möglich ist.

Mit gleichem Erfolg lassen sich auch Homo- oder Copolymere des Maleinimids verwenden. Auch diese Bindemittel zeigen hohe Transparenz im beschriebenen Wellenlängenbereich. Als Comonomere werden auch hier bevorzugt Styrol, substituierte Styrole, Vinylether, Vinylester, Vinylsilylverbindungen oder (Meth)acrylsäureester eingesetzt.

Schließlich sind darüber hinaus auch Copolymere des Styrols mit Comonomeren verwendbar, die in wäßrig alkalischen Lösungen eine Löslichkeitserhöhung bewirken. Hierunter zählen beispielsweise Maleinsäureanhydrid, Maleinsäurehalbester oder dergleichen.

Die genannten Bindemittel können in Mischungen auftreten, sofern sie mischbar sind und die optischen Qualitäten des strahlungsempfindlichen Gemisches nicht verschlechtern. Bevorzugt sind jedoch Bindemittel, enthaltend einen Typus der oben genannten Arten.

Die Menge des Bindemittels betragt im allgemeinen 1 bis 90 Gew.-%, insbesondere 5 bis 90 Gew.-%, vorzugsweise 50 bis 90 Gew.-%, bezogen auf das Gesamtgewicht der strahlungsempfindlichen Mischung.

Ferner können den erfindungsgemäßen strahlungsempfindlichen Gemischen ggf. Farbstoffe, Pigmente, Weichmacher, Netzmittel und Verlaufmittel, aber auch Polyglykole, Celluloseether, z. B. Ethylcellulose, zur Verbesserung spezieller Erfordernisse, wie Flexibilität, Haftung und Glanz, zugesetzt werden.

Vorzugsweise wird das erfindungsgemäße strahlungsempfindliche Gemisch in Lösungsmitteln [.z. B. Ethylenglykol, Glykolether, Glykolmonomethylether, Glykoldimethylether, Glykolmonoethylether oder Propylenglykolmonoalkylether, insbesondere Propylenglykolmethylether, aliphatische Ester (z. B. Ethylacetat, Hydroxyethylacetat, Alkoxyethylacetat, n-Butylacetat, Propylenglykolmonoalkyletheracetat, insbesondere Propylenglykolmethyletheracetat oder Amylacetat), Ether (z. B. Dioxan), Ketone (z. B. Methylethylketon, Methylisobutylketon, Cyclopentanon und Cyclohexanon), Dimethylformamid, Dimethylacetamid, Hexamethylphosphorsäureamid, N-Methylpyrrolidon, Butyrolacton, Tetrahydrofuran und Mischungen derselben] gelöst. Besonders bevorzugt werden Glykolether, aliphatische Ester sowie Ketone.

Letztendlich hängt die Wahl der Lösemittel von dem angewandten Beschichtungsverfahren, der gewünschten Schichtstärke und den Trocknungsbedingungen ab. Ebenso müssen die Lösemittel chemisch neutral sein, d. h. sie dürfen nicht mit den übrigen Schichtkomponenten irreversibel reagieren.

Die mit den Bestandteilen des strahlungsempfindlichen Gemisches entstehenden Lösungen haben in der Regel einen Feststoffgehalt von 5 bis 60 Gew.-%, vorzugsweise bis 50 Gew.-%.

Erfindungsgemäß wird ferner ein strahlungsempfindliches Aufzeichnungsmaterial beansprucht, das im wesentlichen aus einem Substrat und dem darauf aufgetragenen strahlungsempfindlichen Gemisch besteht.

Als Substrate kommen alle Materialien in Frage, aus denen Kondensatoren, Halbleiter, mehrlagige gedruckte Schaltungen oder integrierte Schaltkreise bestehen bzw. hergestellt werden können. Insbesondere sind Oberflächen aus thermisch oxidiertem und/oder mit Aluminium beschichtetem Siliciummaterial zu nennen, die ggf. auch dotiert sein können, einschließlich aller anderen in der Halbleitertechnologie üblichen Substrate, wie beispielsweise Siliciumnitrid, Galliumarsenid und Indiumphosphid. Weiterhin kommen die aus der Flüssigkristalldisplay-Herstellung bekannten Substrate in Frage, wie z. B. Glas und Indium-Zinnoxid, ferner Metallplatten und -folien - beispielsweise aus Aluminium, Kupfer, Zink -, Bimetall- und Trimetallfolien, aber auch elektrisch nicht leitende Folien, die mit Metallen bedampft sind, ggf. mit Aluminium beschichtete SiO₂-Materialien und Papier. Diese Substrate können einer Temperaturvorbehandlung unterzogen werden, oberflächlich aufgerauht, angeätzt oder zur Verbesserung erwünschter Eigenschaften, z. B. der Erhöhung der Hydrophilie, mit Chemikalien behandelt sein.

In einer besonderen Ausführungsform kann das strahlungsempfindliche Gemisch zur besseren Haftung in dem Resist oder zwischen dem Resist und dem Substrat einen Haftvermittler enthalten. Bei Silicium-bzw. Siliciumdioxid-Substraten kommen hierfür Haftvermittler vom Aminosilan-Typ, wie z. B. 3-Aminopropyltriethoxysilan oder Hexamethyl-disilazan, in Frage.

Beispiele für Träger, die zur Herstellung von photomechanischen Aufzeichnungsschichten, wie Druckformen für den Hochdruck, Flachdruck und Siebdruck sowie von Reliefkopien, Verwendung finden können, sind Aluminiumplatten, ggf. anodisch oxidiert, gekörnt und/oder silikatisiert, Zinkplatten und Stahlplatten, die ggf. verchromt wurden, sowie Kunststoffolien oder Papier.

Das erfindungsgemäße Aufzeichnungsmaterial wird bildmäßig belichtet. Quellen aktinischer Strahlung sind: Metallhalogenidlampen, Kohlebogenlampen, Xenonlampen und Quecksilberdampflampen. Ebenso kann eine Belichtung mit energiereicher Strahlung wie Laser-, Elektronen- oder Röntgenstrahlung erfolgen. Besonders bevorzugt sind jedoch Lampen, die Licht einer Wellenlänge von 190 bis 260 nm ausstrahlen können, d.h. insbesondere Xenon- oder/und Quecksilberdampflampen. Darüber hinaus lassen sich auch Laserlichtquellen verwenden, z. B. Excimerlaser, insbesondere KrF- oder ArF-Laser, die bei 249 bzw. 193 nm emittieren. Die Strahlungsquellen müssen in den genannten Wellenlängenbereichen eine ausreichende Emission aufweisen.

Die Schichtstärke variiert in Abhängigkeit von ihrem Einsatzgebiet. Sie beträgt zwischen 0,1 und 100 µm, insbesondere zwischen 1 und 10 µm.

Gegenstand der Erfindung ist ferner ein Verfahren zur Herstellung eines strahlungsempfindlichen Aufzeichnungsmaterials. Das Auftragen des strahlungsempfindlichen Gemisches auf das Substrat kann durch Aufsprühen, Fließbeschichten, Walzen, Schleuder- und Tauchbeschichten erfolgen. Danach wird das Lösungsmittel durch Verdampfen entfernt, so daß auf der Oberfläche des Substrats die strahlungsempfindliche Schicht zurückbleibt. Die Entfernung des Lösungsmittels kann ggf. durch Erhitzen der Schicht auf Temperaturen bis zu 150 °C gefördert werden. Das Gemisch kann aber auch zunächst auf obengenannte Weise auf einen Zwischenträger aufgetragen werden, von dem aus es unter Druck und erhöhter Temperatur auf das endgültige Tragermaterial übertragen wird. Als Zwischenträger können grundsätzlich alle auch als Trägermaterialien ausgewiesene Materialien Anwendung finden. Anschließend wird die Schicht bildmäßig bestrahlt. Danach wird in der strahlungsempfindlichen Schicht durch Entwicklung ein Bildmuster freigelegt, indem die Schicht mit einer Entwicklerlösung behandelt wird, die die bestrahlten Bereiche des Materials löst bzw. entfernt.

Als Entwickler werden Lösungen von Reagenzien wie z.B. Silikaten, Metasilikaten, Hydroxiden, Hydrogen-bzw. Dihydrogenphosphaten, Carbonaten bzw. Hydrogencarbonaten, von Alkali und/oder Erdalkali, insbesondere von Ammoniumionen, aber auch Ammoniak und dergleichen verwendet. Metallionenfreie Entwickler werden in der US-A 4,729,941, der EP-A 0 062 733, der US-A 4 628 023, der US-A 4 141 733, der EP-A 0 097 282 und der EP-A 0 023 758 beschrieben. Der Gehalt dieser Substanzen in der Entwicklerlösung beträgt im allgemeinen 0,1 bis 15 Gew.-%, vorzugweise 0,5 bis 5 Gew.-%, bezogen auf das Gewicht der Entwicklerlösung. Metallionenfreie Entwickler werden insbesondere verwendet. Den Entwicklern können ggf. geringere Mengen eines Netzmittels zugesetzt sein, um die Ablösung der belichteten Stellen im Entwickler zu erleichtern.

Die entwickelten Resiststrukturen werden ggf. nachgehärtet. Dies geschieht im allgemeinen dadurch, daß man die Resiststruktur auf einer hot-plate bis zu einer Temperatur unter der Fließtemperatur erhitzt und anschließend mit UV-Licht einer Xenon-Quecksilber-Dampflampe (Bereich von 200 bis 250 nm) ganzflächig belichtet. Durch diese Nachhärtung werden die Resiststrukturen vernetzt, so daß die Strukturen eine Fließbeständigkeit im allgemeinen bis zu Temperaturen von über 200 °C aufweisen. Die Nachhärtung kann auch ohne Temperaturerhöhung unter Einstrahlung von energiereichem UV-Licht erfolgen.

Bevorzugte Anwendung findet das erfindungsgemäße strahlungsempfindliche Gemisch in lithographischen Prozessen zur Herstellung integrierter Schaltungen oder von diskreten elektrischen Bausteinen. Das aus dem Gemisch hergestellte Aufzeichnungsmaterial dient dabei als Maske für die folgenden Prozeßschritte. Hierunter zählen z. B. das Ätzen des Schichtträgers, die Implantation von Ionen in den Schichtträger oder die Abscheidung von Metallen oder anderen Materialien auf den Schichtträger.

Die nachstehend beschriebenen Beispiele stellen lediglich eine Auswahl der Erfindung dar. Diese soll daher nicht auf die Beispiele begrenzt sein.

Die Beispiele 1 bis 8 belegen die Eignung des erfindungsgemäßen Gemisches für Aufzeichnungsmaterialien in der Mikrolithographie unter Verwendung von Strahlung unterschiedlichster Energie. Anhand der Vergleichsbeispiele 9 und 10 wird die Überlegenheit der erfindungsgemäßen Gemische gegenüber dem Stand der Technik belegt. Die Beispiele 11 und 12 dokumentieren die Anwendbarkeit des Gemisches in gedruckten Schaltungen und Flachdruckplatten.

### Beispiel 1:

Es wurde eine Beschichtungslösung hergestellt aus
- 7,5 GT: eines Kresol-Formaldehyd-Novolaks mit einem Erweichungsbereich von 105 bis 120°C,
- 2,0 GT: p-Methoxybenzaldehyd-bis(phenoxyethyl)-acetal, hergestellt analog dem Herstellungsbeispiel 1 der DE-A 37 30 787, und
- 0,7 GT: Phenylsulfonyl-4-methoxybenzoyl-diazomethan in
- 42 GT: Propylenglykolmonomethyletheracetat.

Die Lösung wurde durch einen Filter mit einem Porendurchmesser von 0,2 µm filtriert und auf einen mit einem Haftvermittler (Hexamethyldisilazan) behandelten Wafer bei 3.200 Umdrehungen aufgeschleudert. Nach der Trocknung auf 100°C für 1 min auf der Hot Plate wurde eine Schichtdicke von 1,1 µm erhalten.

Das Aufzeichnungsmaterial wurde bildmäßig unter einer Vorlage mit der UV-Strahlung einer Xenon-Quecksilberdampflampe bei 365 nm mit einer Energie von 80 mJ/cm² belichtet.

Entwickelt wurde das Aufzeichnungsmaterial mit einem 0,3 n alkalischen Entwickler folgender Zusammensetzung:
- 5,3 GT: Natriummetasilikat x 9 H₂O,
- 3,4 GT: Trinatriumphosphat x 12 H₂O,
- 0,3 GT: Natriumdihydrogenphosphat und
- 91 GT: vollentsalztes Wasser.

Nach einer Entwicklungsdauer von 60 s erhielt man ein fehlerfreies Abbild der Maske mit steilen Resistflanken, wobei auch Strukturen < 1 µm detailgetreu aufgelöst waren. Eine Untersuchung der Flanken der Resistprofile mittels Rasterelektronenmikroskopie belegte, daß diese praktisch senkrecht zur Substratoberfläche ausgerichtet waren.

### Beispiel 2:

Es wurde eine Beschichtungslösung hergestellt aus
- 7,5 GT: eines Copolymeren aus Styrol/p-Hydroxystyrol (20/80) mit einem mittleren Molekulargewicht von 32.000,
- 2,0 GT: 3,4-Dimethoxybenzaldehyd-bis(phenoxyethyl)-acetal, hergestellt analog dem Herstellungsbeispiel 1 der DE-A 37 30 787 und
- 0,7 GT: Phenylsulfonyl-toluoyl-diazomethan in
- 42 GT: Propylenglykolmonomethyletheracetat.

Die Lösung wurde durch einen Filter mit einem Porendurchmesser von 0,2 µm filtriert und auf einen mit einem Haftvermittler (Hexamethyldisilazan) behandelten Wafer bei 3.000 Umdrehungen aufgeschleudert. Nach der Trocknung auf 100°C für 1 min auf der Hot Plate wurde eine Schichtdicke von 1,12 µm erhalten.

Das Aufzeichnungsmaterial wurde bildmäßig unter einer Vorlage mit der UV-Strahlung einer Xenon-Quecksilberdampflampe bei 260 nm mit einer Energie von 92 mJ/cm² belichtet und anschließend mit dem in Beispiel 1 beschriebenen Entwickler verarbeitet.

Nach einer Entwicklungsdauer von 60 s erhielt man ein fehlerfreies Abbild der Maske mit hoher Flankenstabilität, wobei auch hier Strukturen < 1 µm detailgetreu aufgelöst waren.

### Beispiel 3:

Ein entsprechend Beispiel 1 hergestellter Wafer wurde unter einer Vorlage mit UV-Licht einer Wellenlänge von 405 nm mit einer Energie von 100 mJ/cm² bestrahlt. Nach der Entwicklung wurde ein originalgetreues Abbild der Vorlage erhalten.

### Beispiel 4:

Der Versuch von Beispiel 3 wurde wiederholt, jedoch wurde UV-Licht einer Wellenlänge von 436 nm verwendet. Um ein kantenscharfes Abbild der Vorlage zu erhalten mußte eine Belichtungsenergie von 250 mJ/cm² eingesetzt werden.

### Beispiel 5:

Es wurde eine Beschichtungslösung hergestellt aus
- 7,5 GT: eines 1:1 Copolymeren aus Styrol und Maleimid mit einem Erweichungsbereich von 165 bis 180°C,
- 2,0 GT: Benzaldehyd-bis(phenoxyethyl) acetal, hergestellt analog dem Herstellungsbeispiel 1 der DE-A 37 30 787, und
- 0,7 GT: Phenylsulfonyl-(4-chlor-benzoyl)-diazomethan in
- 42 GT: Propylenglykolmonomethyletheracetat.

Die Lösung wurde durch einen Filter mit einem Porendurchmesser von 0,2 µm filtriert und auf einen mit einem Haftvermittler (Hexamethyldisilazan) behandelten Wafer bei 3.700 Umdrehungen aufgeschleudert. Nach der Trocknung auf 100°C für 1 min auf der Hot Plate wurde eine Schichtdicke von 0.98 µm erhalten.

Das Aufzeichnungsmaterial wurde bildmäßig unter einer Vorlage mit der UV-Strahlung einer Xenon-Quecksilberdampflampe bei 260 nm mit einer Energie von 120 mJ/cm² belichtet.

Entwickelt wurde das Aufzeichnungsmaterial mit einer 0,02 n wäßrigen Lösung von Tetramethylammoniumhydroxyd, wobei die belichteten Bereiche innerhalb von 60 s rückstandsfrei abgelöst wurden.

Ein weiteres Mal wurde ein fehlerfreies Abbild der Maske mit steilen Resistflanken erhalten. Der Dunkelabtrag war < 20 nm; auch Strukturen < 1 µm waren detailgetreu aufgelöst.

### Beispiel 6:

Es wurde eine Beschichtungslösung hergestellt aus
- 7,5 GT: eines 1:1 Copolymeren aus Styrol und Maleimid mit einem Erweichungsbereich von 165 bis 180°C,
- 2,0 GT: 3,4-Methylendioxybenzaldehyd-bis(phenoxyethyl)acetal,
- 0,8 GT: 2-Naphthoyl-phenylsulfonyl-diazomethan in
- 42 GT: Propylenglykolmonomethyletheracetat.

Die Lösung wurde durch einen Filter mit einem Porendurchmesser von 0,2 µm filtriert und auf einen mit einem Haftvermittler (Hexamethyldisilazan) behandelten Wafer bei 3.500 Umdrehungen aufgeschleudert. Nach der Trocknung auf 100°C für 1 min auf der Hot Plate wurde eine Schichtdicke von 1,00 µm erhalten.

Das Aufzeichnungsmaterial wurde bildmäßig unter einer Vorlage mit der UV-Strahlung einer Xenon-Quecksilberdampflampe bei 260 nm mit einer Energie von 102 mJ/cm² belichtet.

Entwickelt wurde das Aufzeichnungsmaterial mit einer 0,02 n wäßrigen Lösung von Tetramethylammoniumhydroxyd, wobei die belichteten Bereiche innerhalb von 60 sec rückstandsfrei abgelöst wurden und ein detailgetreues Abbild der Vorlage erhältlich war. Die Kantensteilheit des Bildes war ausgezeichnet.

### Beispiel 7:

Es wurde eine Beschichtungslösung hergestellt aus
- 7,5 GT: des in Beispiel 2 beschriebenen Copolymeren,
- 2,0 GT: eines Polyorthoesters, hergestellt durch Kondensation, von 1 mol 7.7-Bishydroxymethylnonanol mit 1 mol Orthoameisensäuremethylester,
- 0,8 GT: 4-Brombenzoyl-phenylsulfonyl-diazomethan in
- 42 GT: Propylenglykolmonomethyletheracetat.

Die Lösung wurde durch einen Filter mit einem Porendurchmesser von 0,2 µm filtriert und auf einen mit einem Haftvermittler (Hexamethyldisilazan) behandelten Wafer bei 3.500 Umdrehungen aufgeschleudert. Nach der Trocknung auf 100°C für 1 min auf der Hot Plate wurde eine Schichtdicke von 1,04 µm erhalten.

Das Aufzeichnungsmaterial wurde bildmäßig unter einer Vorlage mit der UV-Strahlung einer Xenon-Quecksilberdampflampe bei 260 nm mit einer Energie von 112 mJ/cm² belichtet.

Entwickelt wurde das Aufzeichnungsmaterial mit einer 0,27 n wäßrigen Lösung von Tetramethylammoniumhydroxyd, wobei die belichteten Bereiche innerhalb von 60 s rückstandsfrei abgelöst wurden und ein detailgetreues Abbild der Vorlage erhältlich war. Linien und Spalten bis herab zu 0,7 µm wurden maskengetreu wiedergegeben.

### Beispiel 8:

Das Aufzeichnungsmaterial aus Beispiel 7 wurde mit Synchrotronstrahlung (BESSY, Berlin, 754 MeV) durch eine Gold-auf-Silizium-Maske mit einer Dosis von 180 mJ/cm² bestrahlt. Den experimentellen Aufbau findet man bei A. Heuberger, Microelectr. Eng., 3, 535 (1985). Nach Entwicklung mit dem in Beispiel 7 beschriebenen Entwickler und einer Entwicklungsdauer von 70 sec erhielt man ein fehlerfreies Bild der Maske bis herab zu Strukturen < 0.6 µm. Die Resistflanken waren praktisch senkrecht zur planaren Substratoberfläche.

### Beispiele 9 und 10 (Vergleichsbeispiele):

Die Resistformulierung des Beispiels 7 wurde derart abgeändert, daß die dort verwendete säurebildende Verbindung durch die gleiche Menge von
Triphenylsulfonium-hexafluorophosphat (Beispiel 9) oder 2-Nitrobenzyltosylat (Beispiel 10)
ersetzt wurde. Nach einer Belichtung mit Strahlung einer Wellenlänge von 260 nm und einer Energie von 105 bzw. 140 mJ/cm² sowie Entwicklung mit einem Entwickler der in Beispiel 1 angegebenen Zusammensetzung erhielt man Strukturen, die keine praxisgerechte Bilddifferenzierung zeigten.

Bei Verwendung des Onium-Salzes (Beispiel 9) wurden Strukturen mit sogenanntem "Lackfuß" erhalten, d.h. Resistreste haften in den belichteten Bereichen am Substrat an, während bei Verwendung des Tosylesters (Beispiel 10) Oberflächenvernetzungen sichtbar waren, die die freigelegten Substratflächen teilweise überdachten. In beiden Fällen waren somit keine akzeptablen Strukturierungen erhältlich.

### Beispiel 11:

Für die Herstellung einer Offsetdruckplatte wurde eine Aluminiumfolie mit mechanisch aufgerauhter und anodisierter Oberfläche mit einer Beschichtungslösung nachstehender Zusammensetzung schleuderbeschichtet:
- 7,5 GT: eines Kresol-Formaldehyd-Novolaks mit einem Erweichungsbereich von 105 bis 120°C,
- 2,3 GT: p-Methoxyüenzaldehyd-bis (phenoxyethyl)-acetal,
- 0,5 GT: Phenylsulfonyl-4-brombenzoyl-diazomethan,
- 0,05 GT: Kristallviolettbase in
- 90 GT: Propylenglykolmonomethyletheracetat.

Nach dem Trocknen der Schicht (Schichtgewicht ca. 2,5 g/m²) wurde unter einer positiven Testvorlage 30 s belichtet und mit einem Entwickler folgender Zusammensetzung entwickelt:
- 0,5 GT: Natriumhydroxyd,
- 0,8 GT: Natriummetasilikat x 9 H₂O,
- 1,0 GT: 2-n-Butoxy-ethanol in
- 97,7 GT: vollentsalztem Wasser.

Nach Abspülen mit Wasser wurde die Platte durch Überwischen mit 1%iger Phosphorsäure druckfertig gemacht. Nach dem Einspannen in eine Druckmaschine wurden 55.000 einwandfreie Abdrucke der Vorlage erhalten.

### Beispiel 12:

Die Lösung eines Ätz- und Galvanopositivtrockenresists wurde durch Bereitung nachstehender Zusammensetzung hergestellt:
- 12,5 GT: des in Beispiel 11 beschriebenen Novolaks,
- 10,0 GT: eines oligomeren aliphatischen Polyacetals mit einem mittleren Molekulargewicht von ca. 1400, hergestellt durch Kondensation von Butyraldehyd mit Diethylenglykol,
- 0,5 GT: Phenylsulfonyl-4-t-butylbenzoyl-diazomethan,
- 0,1 GT: Kristallviolett in
- 25 GT: Butanon.

Eine für diesen Zweck übliche Polyethylenterephthalatfolie von 25 µm Dicke wurde mit dieser Lösung beschichtet, so daß sich eine Trockenschichtdicke von 18 µm ergab. Die Oberfläche des trockenen Resistfilms wurde mit einer weiteren Polyethylenterephthalatfolie kaschiert. Der Trockenfilm wurde nach Abziehen der Deckfolie unter Druck und Wärme auf ein Messingblech auflaminiert. Nach Abkühlen und Abziehen der Trägerfolie wurde das Blech durch eine Vorlage hindurch belichtet, wobei ein guter Bildkontrast sichtbar wurde. Die belichteten Stellen wurden mit einem Entwickler der in Beispiel 11 angegebenen Zusammensetzung sprühentwickelt. Das Blech wurde anschließend mit handelsüblicher Ferichlorid-Lösung geätzt, bis die zu glatten Flanken durchgeätzt sind. Die erhaltenen Formteile können vor dem Vereinzeln noch weiter bearbeitet werden.

## Patentansprüche

1. Positiv arbeitendes strahlungsempfindliches Gemisch, im wesentlichen enthaltend
a) 0,5 bis 25 Gew.-% eine Verbindung, die unter Bestrahlung eine Säure bildet,
b) eine Verbindung mit mindestens einer durch Säure spaltbaren C-O-C- oder C-O-Si-Bindung, und
c) ein in Wasser unlösliches, in wäßrig-alkalischen Lösungen lösliches oder zumindest quellbares Bindemittel,
dadurch gekennzeichnet, daß die Verbindung (a) ein α-Carbonyl-α-sulfonyl-diazomethanderivat der allgemeinen Formel I 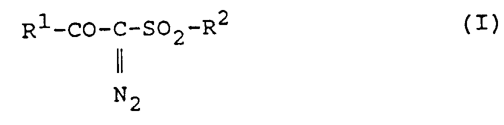 ist, in welchem R¹ und R² unabhängig voneinander einen Alkyl-, Cycloalkyl-, Aryl- oder Heteroarylrest bedeuten.

2. Positiv arbeitendes strahlungsempfindliches Gemisch nach Anspruch 1, dadurch gekennzeichnet, daß die Reste R¹ und R² der Verbindung der allgemeinen Formel I einen ggf. substituierten Alkyl-, oder Cycloalkylrest, einen ggf. substituierten Arylrest oder einen Heteroarylrest bedeuten.

3. Positiv arbeitendes strahlungsempfindliches Gemisch nach den Ansprüchen 1 oder 2, dadurch gekennzeichnet, daß mindestens einer der Reste R¹ und R² der Verbindung der allgemeinen Formel I einen ggf. substituierten Alkylrest mit 1 bis 6 Kohlenstoffatomen oder einen ggf. substituierten Arylrest bedeuten.

4. Positiv arbeitendes strahlungsempfindliches Gemisch nach den Ansprüchen 1 bis 3, dadurch gekennzeichnet, daß mindestens einer der Reste R₁ und R₂ der Verbindung der allgemeinen Formel I einen substituierten Arylrest bedeuten.

5. Positiv arbeitendes strahlungsempfindliches Gemisch nach einem der Ansprüche 1 bis 4, dadurch gekennzeichnet, daß die Substituenten der aromatischen Reste R¹ und R² aus der Gruppe der Alkyl-, Alkoxy-, Alkoxyalkyl-, Cyanoreste oder Halogenatome ausgewählt sind.

6. Positiv arbeitendes strahlungsempfindliches Gemisch nach den Ansprüchen 1 bis 5, dadurch gekennzeichnet, daß als Strahlung Uv-Licht mit einer Wellenlänge von 190 bis 450 nm verwendet wird.

7. Positiv arbeitendes strahlungsempfindliches Gemisch nach den Ansprüchen 1 bis 6, dadurch gekennzeichnet, daß als Strahlung UV-Licht mit einer Wellenlänge von 200 bis 400 nm verwendet wird.

8. Positiv arbeitendes strahlungsempfindliches Gemisch, nach den Ansprüchen 1 bis 7, dadurch gekennzeichnet, daß die Konzentration der säurebildenden Verbindung der allgemeinen Formel I 1 bis 10 Gew.-% beträgt.

9. Positiv arbeitendes strahlungsempfindliches Gemisch nach den Ansprüchen 1 bis 8, dadurch gekennzeichnet, daß das Bindemittel im Wellenlängenbereich der Einstrahlung eine Extinktion von < 0.5 µm⁻¹ aufweist.

10. Positiv arbeitendes strahlungsempfindliches Gemisch nach den Ansprüchen 1 bis 9, dadurch gekennzeichnet, daß das Bindemittel bis zu 30 Gew.-%, insbesondere bis zu 20 Gew.-%, eines Novolak-Kondensationsharzes enthält.

11. Positiv arbeitendes strahlungsempfindliches Gemisch nach den Ansprüchen 9 und 10, dadurch gekennzeichnet, daß das Bindemittel phenolische Hydroxylgruppen enthält.

12. Positiv arbeitendes strahlungsempfindliches Gemisch nach den Ansprüchen 9 bis 11, dadurch gekennzeichnet, daß das Bindemittel in einer Konzentration von 60 bis 96 Gew.-%, insbesondere 70 bis 94 Gew.-%, im strahlungsempfindlichen Gemisch enthalten ist.

13. Positiv arbeitendes strahlungsempfindliches Gemisch nach den Ansprüchen 9 bis 12, dadurch gekennzeichnet, daß das Bindemittel oberhalb 240 nm eine Extinktion von < 0.3 µm⁻¹ aufweist.

14. Positiv arbeitendes strahlungsempfindliches Gemisch nach Anspruch 1, dadurch gekennzeichnet, daß die Verbindung der allgemeinen Formel I von allen Resistbestandteilen bei 248 nm die höchste molare Absorption aufweist.

15. Positiv arbeitendes strahlungsempfindliches Aufzeichungsmaterial, im wesentlichen bestehend aus einem Träger und einer strahlungsempfindlichen Schicht, dadurch gekennzeichnet, daß die Schicht aus einem Gemisch gemäß Ansprüchen 1 bis 14 besteht.

## Claims

1. A positive-working radiation-sensitive mixture essentially containing
a) 0.5 to 25 % by weight of a compound which forms an acid on irradiation,
b) a compound having at least one C-O-C- oder C-O-Si-bond which can be cleaved by acid, and
c) a water-insoluble binder which is soluble or at least swellable in aqueous-alkaline solutions,
wherein the compound (a) is an α-carbonyl-α-sulfonyldiazomethane of the general formula I 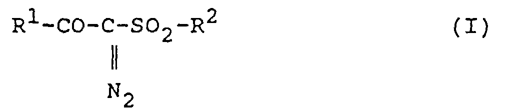 in which
R¹ and R², independently of one another, denote an alkyl-, cycloalkyl-, aryl- or heteroaryl radical.

2. A positive-working radiation-sensitive mixture as claimed in claim 1, wherein the radicals R¹ and R² of the compound of the formula I denote an optionally substituted alkyl or cycloalkyl radical, an optionally substituted aryl radical or a heteroaryl radical.

3. A positive-working radiation-sensitive mixture as claimed in claim 1 or 2, wherein at least one of the radicals R¹ and R² of the compound of the formula I is an optionally substituted alkyl radical containing 1 to 6 carbon atoms or an optionally substituted aryl radical.

4. A positive-working radiation-sensitive mixture as claimed in claims 1 to 3, wherein at least one of the radicals R¹ and R² of the compound of the formula I is an optionally substituted aryl radical.

5. A positive-working radiation-sensitive mixture as claimed in any of claims 1 to 4, wherein the substituents of the aromatic radicals R¹ and R² selected from the group comprising alkyl, alkoxy, alkoxyalkyl and cyano radicals or halogen atoms.

6. A positive-working radiation-sensitive mixture as claimed in claims 1 to 5, wherein UV light having a wavelength of 190 to 450 nm is used as radiation.

7. A positive-working radiation-sensitive mixture as claimed in claims 1 to 6, wherein UV light having a wavelength of 200 to 400 nm is used as radiation.

8. A positive-working radiation-sensitive mixture as claimed in claims 1 to 7, wherein the concentration of the acid-forming compound of the formula I is 1 to 10 % by weight.

9. A positive-working radiation-sensitive mixture as claimed in claims 1 to 8, wherein the binder has an absorbance of < 0.5 µm⁻¹ in the wavelength range of the irradiation.

10. A positive-working radiation-sensitive mixture as claimed in claims 1 to 9, wherein the binder contains up to 30 % by weight, in particular up to 20 % by weight, of a novolak condensation resin.

11. A positive-working radiation-sensitive mixture as claimed in claims 9 and 10, wherein the binder contains phenolic hydroxyl groups.

12. A positive-working radiation-sensitive mixture as claimed in claims 9 to 11, wherein the binder is contained in a concentration of 60 to 96 % by weight, in particular 70 to 94 % by weight, in the radiation-sensitive mixture.

13. A positive-working radiation-sensitive mixture as claimed in claims 9 to 12, wherein the binder has an absorbance of < 0.3 µm⁻¹ above 240 nm.

14. A positive-working radiation-sensitive mixture as claimed in claim 1, wherein the compound of the formula I has the highest molar absorption of all the resist constituents at 248 nm.

15. A positive-working radiation-sensitive copying material essentially composed of a support and a radiation-sensitive layer, wherein the layer is composed of a mixture as claimed in claims 1 to 14.

## Revendications

1. Composition sensible aux rayonnements travaillant en positif contenant essentiellement
a) 0,5 à 25% en poids d'un composé qui forme un acide par insolation,
b) un composé avec au moins une liaison C-O-C ou C-O-Si clivable par un acide, et
c) un liant insoluble dans l'eau, soluble ou au moins capable de gonfler dans des solutions aqueuses alcalines,
caractérisé en ce que, le composé (a) est un dérivé α-carbonyl-α-sulfonyl-diazométhane de Formule générale I 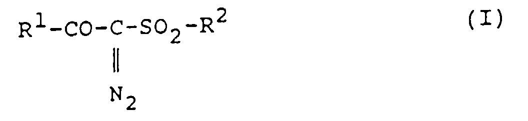 dans laquelle R¹ et R² signifient indépendamment l'un de l'autre un radical alkyle, cycloalkyle, aryle ou hétéroaryle.

2. Composition sensible aux rayonnements travaillant en positif selon la revendication 1, caractérisée en ce que, les radicaux R¹ et R² du composé de Formule générale I signifient un radical alkyle ou cycloalkyle éventuellement substitué, un radical aryle éventuellement substitué ou un radical hétéroaryle.

3. Composition sensible aux rayonnements travaillant en positif selon les revendications 1 ou 2, caractérisée en ce que, l'un au moins des radicaux R¹ et R² du composé de Formule générale I signifie un radical alkyle éventuellement substitué de 1 à 6 atomes de carbone ou un radical aryle éventuellement substitué.

4. Composition sensible aux rayonnements travaillant en positif selon les revendications 1 à 3, caractérisée en ce que, l'un au moins des radicaux R¹ et R² du composé de Formule générale I signifie un radical aryle substitué.

5. Composition sensible aux rayonnements travaillant en positif selon les revendications 1 à 4, caractérisée en ce que, les substituants des radicaux aromatiques R¹ et R² sont choisis dans le groupe des radicaux alkyle, alcoxy, alcoxyalkyle, cyano ou des atomes d'halogènes.

6. Composition sensible aux rayonnements travaillant en positif selon les revendications 1 à 5, caractérisée en ce que, l'on utilise comme rayonnement de la lumière U.V. avec une longueur d'onde de 190 à 450 nm.

7. Composition sensible aux rayonnements travaillant en positif selon les revendications 1 à 6, caractérisée en ce que, l'on utilise comme rayonnement de la lumière U.V. avec une longueur d'onde de 200 à 400 nm.

8. Composition sensible aux rayonnements travaillant en positif selon les revendications 1 à 7, caractérisée en ce que, la concentration du composé de Formule générale I formant un acide est de 1 à 10% en poids.

9. Composition sensible aux rayonnements travaillant en positif selon les revendications 1 à 8, caractérisée en ce que, le liant présente une absorbance < 0,5 µm⁻¹ dans le domaine de longueur d'onde de l'insolation.

10. Composition sensible aux rayonnements travaillant en positif selon les revendications 1 à 9, caractérisée en ce que, le liant contient jusqu'à 30% en poids, plus particulièrement jusqu'à 20% en poids d'une résine de condensation de type Novolaque.

11. Composition sensible aux rayonnements travaillant en positif selon les revendications 9 et 10, caractérisée en ce que, le liant contient des groupes hydroxyles de type phénolique.

12. Composition sensible aux rayonnements travaillant en positif selon les revendications 9 à 11, caractérisée en ce que, le liant est contenu dans la composition sensible aux rayonnements en une concentration de 60 à 96% en poids, plus particulièrement de 70 à 94% en poids.

13. Composition sensible aux rayonnements travaillant en positif selon les revendications 9 à 12, caractérisée en ce que, le liant présente au-dessus de 240 nm une absorbance < 0,3 µm⁻¹.

14. Composition sensible aux rayonnements travaillant en positif selon la revendication 1, caractérisée en ce que, le composé de Formule générale I présente à 248 nm la plus forte absorption molaire de tous les constituants du resist.

15. Matériau d'enregistrement sensible aux rayonnements travaillant en positif constitué essentiellement d'un support et d'une couche sensible aux rayonnements, caractérisé en ce que, la couche consiste en une composition selon les revendications 1 à 14.
